(19) Europäisches Patentamt
European Patent Office
Office européen des brevets

(11) EP 0 898 366 A1

(12) DEMANDE DE BREVET EUROPEEN

(43) Date de publication:
24.02.1999 Bulletin 1999/08

(51) Int Cl.⁶: H03K 17/725, H01H 9/54

(21) Numéro de dépôt: 98402086.7

(22) Date de dépôt: 20.08.1998

(84) Etats contractants désignés:
AT BE CH CY DE DK ES FI FR GB GR IE IT LI LU
MC NL PT SE
Etats d'extension désignés:
AL LT LV MK RO SI

(30) Priorité: 22.08.1997 FR 9710574

(71) Demandeurs:
• LEGRAND
F-87000 Limoges (FR)

• LEGRAND SNC
F-87000 Limoges (FR)

(72) Inventeur: Cousy, Jean-Pierre
87430 Verneuil Sur Vienne (FR)

(74) Mandataire: CABINET BONNET-THIRION
12, Avenue de la Grande-Armée
75017 Paris (FR)

(54) Interrupteur électronique

(57) Il s'agit d'un interrupteur électronique du genre comportant, interposé entre une borne d'entrée (B1) et une borne de sortie (B2), un organe de coupure électronique (13) piloté par un circuit de commande (14), qui s'étend de son anode (15) à sa gâchette (16), et qui est sous le contrôle d'un organe d'actionnement (17) sur lequel peut intervenir, soit directement, soit indirectement, l'usager, avec, en série sur ce circuit de commande (14), une résistance de limitation de courant (18).

Suivant l'invention, la valeur de la résistance de limitation de courant (18) est inférieure à la valeur du front de tension à l'amorçage de l'organe de coupure électronique (13) divisée par la valeur du courant de gâchette minimal nécessaire à cet organe de coupure électronique (13) pour cet amorçage ; par exemple, elle est au plus de l'ordre de 40 ohms.

Application à la commande d'une charge sans génération d'harmoniques parasites gênantes sur le réseau.

FIG.1

## Description

La présente invention concerne d'une manière générale les interrupteurs électroniques du genre comportant, interposé entre une borne d'entrée et une borne de sortie par lesquelles il peut être inséré sur le circuit de puissance d'une quelconque charge à commander, un organe de coupure électronique, par exemple un triac, piloté par un circuit de commande qui est sous le contrôle d'un organe d'actionnement sur lequel peut intervenir, soit directement, soit indirectement, l'usager.

Le plus souvent, à ce jour, et cela est le cas notamment dans les réalisations pratiques les plus communément mises en oeuvre, le circuit de commande bénéficie d'une alimentation particulière, qui, au prix d'un câblage supplémentaire approprié, est prise directement entre la phase et le neutre du circuit de puissance correspondant.

Il a cependant été envisagé que ce circuit de commande soit établi de l'anode à la gâchette de l'organe de coupure électronique, ce qui évite tout câblage supplémentaire, et ce qui permet en outre avantageusement un amorçage automatique de l'organe de coupure électronique lors même du passage du courant à zéro.

Ce circuit de commande comporte alors inévitablement en série une résistance de limitation de courant, dont la valeur doit être appropriée à l'amorçage recherché, et qui, de ce fait, est fréquemment appelée résistance de déclenchement.

Il est à ce jour considéré comme acquis que la valeur de cette résistance de limitation de courant doit être relativement élevée, en étant en pratique de l'ordre 100 ohms.

Or, cette résistance de limitation de courant constitue un filtre avec la capacité interne qui existe inévitablement entre la gâchette et l'anode de l'organe de coupure électronique.

Il en résulte, tout aussi inévitablement, un certain déphasage entre le courant et la tension.

Lorsque la valeur de la résistance de limitation de courant est élevée, l'angle de ce déphasage, communément appelé angle de conduction, est suffisamment important pour que, au zéro du courant, et, donc, à l'amorçage, le front de tension correspondant ait lui-même une amplitude importante.

Il en résulte intempestivement la génération, sur le circuit de puissance, d'harmoniques parasites susceptibles d'être à la source d'une gêne pour le réseau correspondant.

Pour obvier à cette difficulté, et il est nécessaire de le faire pour satisfaire les dispositions normatives en la matière, il est usuel, à ce jour, d'insérer, sur le circuit de puissance, une bobine de lissage.

Mais, outre son coût, qui n'est pas négligeable, et les frais d'assemblage qu'elle implique, cette bobine de lissage a pour inconvénient majeur d'être à l'origine d'une dissipation thermique importante.

Lorsqu'elle intervient dans un environnement confiné, comme cela est par exemple le cas au sein d'une boîte d'encastrement, cette dissipation thermique conduit en pratique à une réduction considérable du pouvoir de coupure de l'organe de coupure électronique mis en oeuvre, pour que la température limite à ne pas dépasser soit respectée.

Le plus souvent, ce pouvoir de coupure est réduit de moitié.

Une autre solution également déjà connue consiste à remplacer par une capacité la résistance de limitation de courant.

Mais il en résulte l'inconvénient d'introduire un déphasage de 90° entre le courant et la tension.

La présente invention a d'une manière générale pour objet une disposition permettant d'éviter ces inconvénients.

Elle est fondée sur l'observation, à ce jour non formulée, qu'il est possible, sans nuire au fonctionnement, de choisir la valeur de la résistance de limitation de courant de manière à ce que l'angle de conduction subsistant ne conduise qu'à des harmoniques parasites admissibles.

De manière plus précise, la présente invention a pour objet un interrupteur électronique du genre comportant, interposé entre une borne d'entrée et une borne de sortie, un organe de coupure électronique piloté par un circuit de commande, qui s'étend de son anode à sa gâchette, et qui est sous le contrôle d'un organe d'actionnement sur lequel peut intervenir, soit directement, soit indirectement, l'usager, avec, en série sur ce circuit de commande, une résistance de limitation de courant, cet interrupteur électronique étant d'une manière générale caractérisé en ce que la valeur de la résistance de limitation de courant est inférieure à la valeur du front de tension à l'amorçage de l'organe de coupure électronique divisée par la valeur du courant de gâchette minimal nécessaire à l'organe de coupure électronique pour cet amorçage.

Par exemple, la valeur de cette résistance de limitation de courant est au plus de l'ordre de 40 ohms.

Avec une résistance de limitation de courant de valeur aussi réduite, l'angle de conduction a lui-même une valeur limitée, qui est en pratique au plus de l'ordre de quelques dixièmes de degré.

Par suite, le front de tension au passage du courant à zéro reste largement inférieur au dixième de l'amplitude maximale de cette tension, en étant par exemple au plus de l'ordre de quelques volts, en sorte que, comme recherché, les harmoniques parasites correspondantes restent dans des limites acceptables, sans entraîner une réelle gêne sur le circuit de puissance concerné.

L'interrupteur électronique suivant l'invention présente en outre d'autres avantages.

Tout d'abord, il se satisfait avantageusement d'une réalisation ne mettant en oeuvre qu'un nombre minimal de composants.

Il est également avantageusement susceptible d'être commandé par des interrupteurs tactiles, en bénéficiant ainsi des avantages de faible course et de faible bruit de ceux-ci.

Intervenant par ailleurs uniquement entre phase et phase coupée, sans raccordement au neutre, l'interrupteur électronique suivant l'invention peut avantageusement être commandé à distance.

Il est également avantageusement susceptible d'assurer la coupure de charges électriques de forte puissance, qu'il s'agisse de charges incandescentes ou qu'il s'agisse de charges fluorescentes, à un faible coût, sous un faible encombrement, sans création d'arc susceptible de conduire à une détérioration importante de quelconques contacts électriques, et en respectant les dispositions normatives en matière de dissipation thermique, même dans une boîte d'encastrement.

Si nécessaire, une protection thermique peut d'ailleurs être assurée, en mettant en oeuvre, pour résistance de limitation de courant, une résistance à coefficient de température positif.

Suivant un développement de l'invention, l'interrupteur électronique suivant l'invention se prête en outre avantageusement à la constitution d'un va-et-vient.

Il comporte alors, pour ce faire, en parallèle, deux organes de coupure électroniques, à chacun desquels est associée une borne de sortie distincte, et dont les circuits de commande ont en commun la résistance de limitation de courant et l'organe d'actionnement, cet organe d'actionnement étant alors un inverseur apte à fermer alternativement l'un ou l'autre de ces circuits de commande.

Les caractéristiques et avantages de l'invention ressortiront d'ailleurs de la description qui va suivre, à titre d'exemple, en référence aux dessins schématiques annexés sur lesquels :

la figure 1 est un schéma de principe d'un interrupteur électronique suivant l'invention ;
la figure 2 est un diagramme illustrant son fonctionnement ;
la figure 3 est un schéma de principe d'un montage va-et-vient mettant en oeuvre deux interrupteurs va-et-vient électroniques suivant l'invention.

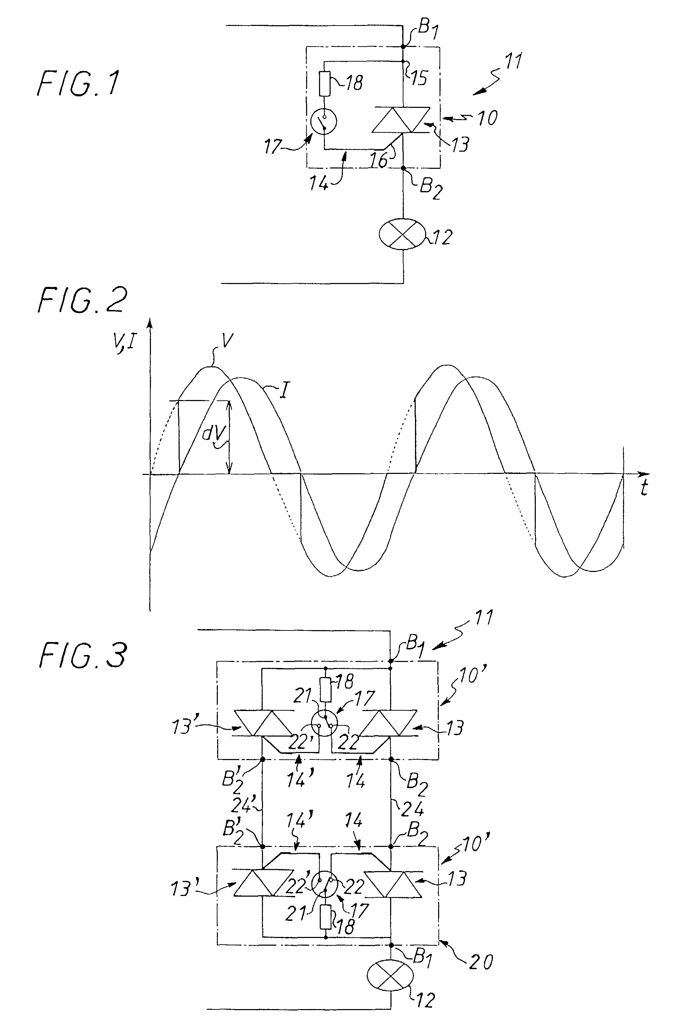

Tel qu'illustré sur la figure 1, et de manière connue en soi, un interrupteur 10 suivant l'invention comporte, interposé entre une borne d'entrée B1 et une borne de sortie B2 par lesquelles il est apte à être inséré sur un circuit de puissance 11 desservant la charge 12 à commander, un organe de coupure électronique 13 piloté par un circuit de commande 14, qui s'étend de son anode 15 à sa gâchette 16, et qui est sous le contrôle d'un organe d'actionnement 17 sur lequel peut intervenir, soit directement, soit indirectement, l'usager, avec, en série sur ce circuit de commande 14, une résistance de limitation de courant 18.

Sur le diagramme de la figure 2 on a reporté, de manière usuelle, en abscisses, le temps t, et, en ordonnées, la tension V aux bornes de l'organe de coupure électronique 13 et l'intensité I qui traverse celui-ci.

Soit dV le front de tension à l'amorçage de l'organe de coupure électronique 13, c'est-à-dire la valeur de la tension V au passage par zéro du courant I.

Suivant l'invention, la valeur R de la résistance de limitation de courant 18 est inférieure à la valeur dV du front de tension à l'amorçage de l'organe de coupure électronique 13 divisée par la valeur $I_{GT}$ du courant de gâchette minimal nécessaire à cet organe de coupure électronique 13 pour cet amorçage.

Autrement dit :

$$R = \frac{dV}{I_{GT}}$$

Préférentiellement, la valeur R de la résistance de limitation de courant 18 est au plus de l'ordre de 40 ohms.

Il est ainsi possible d'obtenir par exemple un front de tension au plus égal à 1 V avec un courant de gâchette de l'ordre de 25 mA.

Dans la forme de réalisation représentée, l'organe de coupure électronique 13 est un triac.

Quant à l'organe d'actionnement 17, il peut s'agir par exemple d'un microrupteur ou d'un interrupteur à commande tactile, en étant, dans l'un et l'autre cas, directement à la disposition de l'usager.

Mais, en variante, il peut s'agir d'un quelconque moyen de coupure susceptible d'être commandé indirectement, en étant par exemple commandé à distance.

Si désiré, la résistance de limitation de courant 18 mise en oeuvre peut être une résistance à coefficient de température positif, qui, dans le cas d'une température trop élevée dans le boîtier dans lequel l'ensemble est implanté, conduit à un blocage de l'organe de coupure électronique 13, par saturation de son courant de gâchette.

Tel qu'illustré sur la figure 3, un montage va-et-vient 20 suivant l'invention comporte deux interrupteurs électroniques 10', qui sont alors des interrupteurs électroniques va-et-vient, disposés tête-bêche.

Ainsi, pour l'un de ces interrupteurs électroniques 10', la borne d'entrée B1 est, comme précédemment, disposée du côté opposé à la charge 12, tandis que, pour l'autre de ces interrupteurs électroniques 10', elle est disposée du côté de cette charge 12.

Pour la constitution d'un tel montage va-et-vient 20, l'interrupteur électronique 10' suivant l'invention comporte, en parallèle, deux organes de coupure électronique 13, 13', à chacun desquels est associée une borne de sortie B2, B'2 distincte, et dont les circuits de commande 14, 14' ont en commun la résistance de limitation de courant 18 et l'organe d'actionnement 17,

cet organe d'actionnement 17 étant alors un inverseur apte à fermer alternativement l'un ou l'autre de ces circuits de commande 14, 14'.

Par exemple, et tel que représenté, cet organe d'actionnement 17 est alors branché, par sa borne centrale 21, sur la résistance de limitation de courant 18, tandis que, par ses bornes latérales 22, 22', il est relié à la gâchette 16, 16' des organes de coupure électroniques 13, 13'.

Les bornes de sortie B2 des deux interrupteurs électroniques 10' sont reliées l'une à l'autre par un fil conducteur navette 24, et, parallèlement, leurs bornes de sortie B'2 sont reliées l'une à l'autre par un fil conducteur navette 24'.

Ces fils conducteurs navettes 24, 24' appartiennent en pratique à l'installation électrique correspondante.

Pour chacun des interrupteurs électroniques 10', les organes de coupure électroniques 13, 13' sont alternativement passants et bloqués.

L'ensemble est passant lorsqu'un même organe de coupure électronique 13 ou 13' est passant dans l'un et l'autre des deux interrupteurs électroniques 10', et il est bloqué dans le cas contraire.

Dans l'un et l'autre cas, il est possible de changer l'état de l'ensemble, et, donc, d'assurer, ou non, l'alimentation de la charge 12, en intervenant sur l'un ou l'autre des organes d'actionnement 17.

En effet, à chaque intervention sur un tel organe d'actionnement 17, les organes de coupure électroniques 13, 13' de l'interrupteur électronique 10' correspondant changent l'un et l'autre d'état.

Par exemple, dans la configuration représentée sur la figure 3, pour chacun des interrupteurs électroniques 10', l'organe de coupure électronique 13 est passant tandis que l'organe de coupure électronique 13' est bloqué, et la charge 12 est alimentée.

Si, à partir d'une telle configuration, il est agi sur l'organe d'actionnement 17 de l'un ou l'autre des interrupteurs électroniques 10', l'organe de coupure électronique 13 de cet interrupteur électronique 10' devient bloqué, ce qui coupe l'alimentation de la charge 12.

Si, ensuite, il est agi sur l'organe d'actionnement 17 de l'autre interrupteur électronique 10', les organes de coupure électroniques 13' de chacun des deux interrupteurs électroniques 10' deviennent simultanément passants, ce qui assure à nouveau l'alimentation de la charge 12, cependant que l'organe de coupure électronique 13 de cet autre interrupteur électronique 10' est à son tour bloqué.

A partir de la nouvelle configuration de l'ensemble, qui est inverse de la précédente, un processus identique à celui précédemment décrit se développe s'il est agi sur l'organe d'actionnement 17 de l'un ou l'autre des interrupteurs électroniques 10'.

Bien entendu, la présente invention ne se limite pas aux formes de réalisation décrites et représentées, mais englobe toute variante d'exécution.

## Revendications

1. Interrupteur électronique du genre comportant, interposé entre une borne d'entrée (B1) et une borne de sortie (B2), un organe de coupure électronique (13) piloté par un circuit de commande (14), qui s'étend de son anode (15) à sa gâchette (16), et qui est sous le contrôle d'un organe d'actionnement (17) sur lequel peut intervenir, soit directement, soit indirectement, l'usager, avec, en série sur ce circuit de commande (14), une résistance de limitation de courant (18), caractérisé en ce que la valeur (R) de la résistance de limitation de courant (18) est inférieure à la valeur (dV) du front de tension à l'amorçage de l'organe de coupure électronique (13) divisée par la valeur ($I_{GT}$) du courant de gâchette minimal nécessaire à cet organe de coupure électronique (13) pour cet amorçage.

2. Interrupteur électronique suivant la revendication 1, caractérisé en ce que la valeur (R) de la résistance de limitation de courant (18) est au plus de l'ordre de 40 ohms.

3. Interrupteur électronique suivant l'une quelconque des revendications 1, 2, caractérisé en ce que l'organe de coupure électronique (13) est un triac.

4. Interrupteur électronique suivant l'une quelconque des revendications 1 à 3, caractérisé en ce que, pour la constitution d'un va-et-vient, il comporte, en parallèle, deux organes de coupure électroniques (13, 13'), à chacun desquels est associée une borne de sortie (B2, B'2) distincte, et dont les circuits de commande (14, 14') ont en commun la résistance de limitation de courant (18) et l'organe d'actionnement (17), cet organe d'actionnement (17) étant alors un inverseur apte à fermer alternativement l'un ou l'autre de ces circuits de commande (14, 14').

FIG.1

FIG.2

FIG.3

**Office européen des brevets**

**RAPPORT DE RECHERCHE EUROPEENNE**

Numéro de la demande

EP 98 40 2086

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | G. HALL: "Triacs can misfire with the wrong triggering" ELECTRONIC ENGINEERING., vol. 45, no. 544, juin 1973, pages 65-67, XP002058509 LONDON GB | 1-3 | H03K17/725 H01H9/54 |
| Y | * page 66, colonne de droite, ligne 1 - ligne 15; figure 1 * | 4 | |
| X | STEVENS: "A.C. full-wave static switch" NEW ELECTRONICS, vol. 10, no. 1, 11 janvier 1977, pages 40-43, XP002058510 LONDON * colonne du milieu, ligne 3 - ligne 17; figure 1 * | 1-3 | |
| X | CHRIST: "Leistungssteuerung und -regelung mit Triacs" ELEKTRONIK., vol. 26, no. 12, décembre 1977, pages 37-40, XP002058511 MUNCHEN DE * page 37, colonne de gauche, alinéa 1; figure 1 * | 1-3 | DOMAINES TECHNIQUES RECHERCHES (Int.Cl.6) H03K H01H |
| X | MCNULTY: "POWER SWITCHING USING SOLID-STATE RELAY" IEEE INTERCON TECHNICAL PAPERS, COMPUTERS IN PUBLIC SYSTEMS, 26 - 30 mars 1973, pages 32/2 1-32/2 5, XP002058512 NEW YORK * page 3, colonne de droite, ligne 1 - ligne 24; figure 4 * | 1-3 | |
| Y | FR 2 579 008 A (PETERCEM SA) 19 septembre 1986 * figure 3 * | 4 | |

-/--

Le présent rapport a été établi pour toutes les revendications

| Lieu de la recherche | Date d'achèvement de la recherche | Examinateur |
|---|---|---|
| LA HAYE | 8 décembre 1998 | Segaert, P |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

| Office européen des brevets | **RAPPORT DE RECHERCHE EUROPEENNE** | Numéro de la demande EP 98 40 2086 |
|---|---|---|

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | HOWELL ET AL.: "Applying SCRs to Consumer Products" ELECTRONIC INDUSTRIES, vol. 25, no. 7, juillet 1966, pages 52-55, XP002058513 * page 55, colonne de droite, ligne 14 - ligne 28; figure 8 *  ----- | 1-4 | |

DOMAINES TECHNIQUES RECHERCHES (Int.Cl.6)

Le présent rapport a été établi pour toutes les revendications

| Lieu de la recherche | Date d'achèvement de la recherche | Examinateur |
|---|---|---|
| LA HAYE | 8 décembre 1998 | Segaert, P |